# EUROPEAN PATENT APPLICATION

(11) **EP 4 756 561 A1**
(43) Date of publication of application: **10.06.2026**
(21) Application number: 25218938.6
(22) Date of filing: 27.11.2025
(51) Int. Cl.: G06F 1/10, H03L 7/06

(54) **SYSTEMS AND METHODS FOR MITIGATING CLOCK SIGNAL DRIFT**

(30) Priority: 05.12.2024 US 202463728548 P; 07.07.2025 US 202519261948
(71) Applicant: Samsung Electronics Co., Ltd., Suwon-si, Gyeonggi-do 16677 (KR)
(72) Inventor: KANG, Dae Hyun, San Jose, CA, 95134 (US); KIM, Jaehyup, San Jose, CA, 95134 (US); PARK, Joung Won, San Jose, CA, 95134 (US); KIM, Hyojun, San Jose, CA, 95134 (US)
(74) Representative: Kuhnen & Wacker Patent- und Rechtsanwaltsbüro PartG mbB

(57) **Abstract**

A method is provide which comprises: determining a first value of a signal at a first clock edge of a clock signal; determining a second value of the signal at a second clock edge of the clock signal; generating an output value based on a computation of at least the first value and the second value; determining a status of the clock signal based on a comparison between the output value and a reference value; and adjusting the clock signal based on the status. A system comprising a processing circuit and a memory storing instructions, which, based on being executed by the processing circuit, cause the processing circuit to perform the method is also provided.

## Description

### FIELD

One or more aspects of embodiments according to the present disclosure relate to electronic circuits, and more particularly to systems and methods for mitigating clock signal drift in electronic circuits.

### BACKGROUND

Digital circuits are often found in devices like microprocessors, memory systems, and communication interfaces. Digital circuits may be used to process, store, and transmit digital data, enabling complex functionalities such as computation, information storage, and signal processing. Digital circuits may utilize a clock signal that is calibrated to a data signal to provide a timing reference for coordinating and/or synchronizing the operation of various components in the circuit. The effects of voltage and temperature variations in the circuit may cause the clock signal to drift out of phase from the data signal during runtime.

The above information disclosed in this Background section is only for enhancement of understanding of the background of the present disclosure, and therefore, it may contain information that does not form prior art.

### SUMMARY

According to some embodiments of the present disclosure, there is provided a method comprising: determining a first value of a signal at a first clock edge of a clock signal; determining a second value of the signal at a second clock edge of the clock signal; generating an output value based on a computation of at least the first value and the second value; determining a status of the clock signal based on a comparison between the output value and a reference value; and adjusting the clock signal based on the status.

In some embodiments, the determining the status includes identifying the clock signal as leading with respect to the signal, and wherein the adjusting of the clock signal includes increasing a delay of the clock signal.

In some embodiments, the determining the status includes identifying the clock signal as lagging with respect to the signal, and wherein the adjusting of the clock signal includes advancing the clock signal.

In some embodiments, the computation includes at least one of a sum, average, or mode of at least the first value and the second value.

In some embodiments, the sum is based on a plurality of values taken at a plurality of clock edges, the plurality of values including the first value and the second value, and wherein the reference value is based on the number of values in the plurality of values.

In some embodiments, the reference value is based on the number of the values divided by two.

In some embodiments, the clock signal includes K number of phases, and the method further comprises: determining one or more values of the signal taken at one or more K^{th} clock edge; determining one or more values of the signal taken at one or more K^{th}+M clock edge, where M is equal to or greater than 1 and less than K; determining a first sum of the one or more values of the signal taken at the one or more K^{th} clock edge; determining a second sum of the one or more values of the signal taken at the one or more K^{th}+M clock edge; comparing the first sum to the reference value; comparing the second sum to the reference value; determining a first status based on the comparison between the first sum and the reference value; determining a second status based on the comparison between the second sum and the reference value; and determining the status of the clock signal based at least in part on the first status and the second status.

In some embodiments, wherein the first status is one of leading, lagging, or aligned with respect to the signal, and wherein the second status is one of leading, lagging, or aligned with respect to the signal, and wherein the method further comprises: determining the status of the clock signal as leading with respect to the signal based on a majority of at least the first status and the second status being leading with respect to the signal.

In some embodiments, the first status is one of leading, lagging, or aligned with respect to the signal, and wherein the second status is one of leading, lagging, or aligned with respect to the signal, and wherein the method further comprises: determining the status of the clock signal as lagging with respect to the signal based on a majority of at least the first status and the second status being lagging with respect to the signal.

In some embodiments, the reference value is calculated based on an assumption of jitter in the clock signal.

According to some embodiments of the present disclosure, there is provided a system comprising: a processing circuit; and a memory storing instructions, which, based on being executed by the processing circuit, cause the processing circuit to perform: determining a first value of a signal at a first clock edge of a clock signal; determining a second value of the signal at a second clock edge of the clock signal; generating an output value based on a computation of at least the first value and the second value; determining a status of the clock signal based on a comparison between the output value and a reference value; and adjusting the clock signal based on the status.

In some embodiments, the determining the status includes identifying the clock signal as leading with respect to the signal, and wherein the adjusting of the clock signal includes increasing a delay of the clock signal.

In some embodiments, the determining the status includes identifying the clock signal as lagging with respect to the signal, and wherein the adjusting of the clock signal includes advancing the clock signal.

In some embodiments, the computation includes at least one of a sum, average, or mode of at least the first value and the second value.

In some embodiments, the sum is based on a plurality of values taken at a plurality of clock edges, the plurality of values including the first value and the second value, and wherein the reference value is based on the number of values in the plurality of values.

In some embodiments, the reference value is based on the number of the values divided by two.

In some embodiments, the clock signal includes K number of phases, and the instructions, based on being executed by the processing circuit, further cause the processing circuit to perform: determining one or more values of the signal taken at one or more K^{th} clock edge; determining one or more values of the signal taken at one or more K^{th}+M clock edge, where M is equal to or greater than 1 and less than K; determining a first sum of the one or more values of the signal taken at the one or more K^{th} clock edge; determining a second sum of the one or more values of the signal taken at the one or more K^{th}+M clock edge; comparing the first sum to the reference value; comparing the second sum to the reference value; determining a first status based on the comparison between the first sum and the reference value; determining a second status based on the comparison between the second sum and the reference value; and determining the status of the clock signal based at least in part on the first status and the second status.

In some embodiments, the first status is one of leading, lagging, or aligned with respect to the signal, and wherein the second status is one of leading, lagging, or aligned with respect to the signal, and wherein the method further comprises: determining the status of the clock signal as leading with respect to the signal based on a majority of at least the first status and the second status being leading with respect to the signal.

In some embodiments, the first status is one of leading, lagging, or aligned with respect to the signal, and wherein the second status is one of leading, lagging, or aligned with respect to the signal, and wherein the method further comprises: determining the status of the clock signal as lagging with respect to the signal based on a majority of at least the first status and the second status being lagging with respect to the signal.

In some embodiments, the reference value is calculated based on an assumption of jitter in the clock signal.

These and other features, aspects and advantages of the embodiments of the present disclosure will be more fully understood when considered with respect to the following detailed description, appended claims, and accompanying drawings. Of course, the actual scope of the invention is defined by the appended claims.

### BRIEF DESCRIPTION OF THE DRAWINGS

Non-limiting and non-exhaustive embodiments of the present embodiments are described with reference to the following figures, wherein like reference numerals refer to like parts throughout the various views unless otherwise specified.
Fig. 1 depicts a block diagram of an electronic device, according to one or more embodiments.
Fig. 2 depicts a block diagram of components of the electronic device of Fig. 1, according to one or more embodiments.
Fig. 3 depicts a timing diagram of the clock signal in the presence of jitter, according to one or more embodiments.
Fig. 4 depicts a timing diagram associated a clock signal in half-rate mode exhibiting a leading phase shift with respect to a track signal, according to one or more embodiments.
Fig. 5 depicts a timing diagram associated with the clock signal in half-rate mode exhibiting a lagging phase shift with respect to the track signal, according to one or more embodiments.
Fig. 6 depicts a schematic representation of example tracks where track signal values are sampled at respective clock edges, according to one or more embodiments.
Fig. 7 depicts a table of expected sum of track signal values for determining clock signal status when the clock signal is in half-rate mode, according to one or more embodiments.
Fig. 8 depicts a timing diagram associated with a clock signal in quarter-rate mode exhibiting a leading phase shift with respect to a track signal, according to one or more embodiments.
Fig. 9 depicts a timing diagram associated with the clock signal in quarter-rate mode exhibiting a lagging phase shift with respect to the track signal, according to one or more embodiments.
Fig. 10 depicts a schematic representation of example tracks where track signal values are sampled at respective clock edges, according to one or more embodiments.
Fig. 11 depicts a table of expected sum of track signal values for determining clock signal status when the clock signal is in quarter-rate mode, according to one or more embodiments.
Fig. 12 depicts a flow diagram of a process for detecting and mitigating clock signal drift, according to one or more embodiments.
Fig. 13 depicts a flow diagram of a process for detecting and mitigating clock signal drift for a multi-phase clock signal, according to one or more embodiments.
Fig. 14 depicts a flow diagram of a process for detecting and mitigating clock signal drift for a four-phase clock signal in half-rate mode, according to one or more embodiments.
Fig. 15 depicts a flow diagram of a process for detecting and mitigating clock signal drift for a four-phase clock signal in quarter-rate mode, according to one or more embodiments.

### DETAILED DESCRIPTION

Hereinafter, example embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, descriptions thereof may not be repeated. Further, in the drawings, the relative sizes of elements, layers, and regions may be exaggerated and/or simplified for clarity.

Embodiments of the present disclosure are described below with reference to block diagrams and flow diagrams. Thus, it should be understood that each block of the block diagrams and flow diagrams may be implemented in the form of a computer program product, an entirely hardware embodiment, a combination of hardware and computer program products, and/or apparatus, systems, computing devices, computing entities, and/or the like carrying out instructions, operations, steps, and similar words used interchangeably (for example the executable instructions, instructions for execution, program code, and/or the like) on a computer-readable storage medium for execution. For example, retrieval, loading, and execution of code may be performed sequentially such that one instruction is retrieved, loaded, and executed at a time. In some example embodiments, retrieval, loading, and/or execution may be performed in parallel such that multiple instructions are retrieved, loaded, and/or executed together. Thus, such embodiments can produce specifically-configured machines performing the steps or operations specified in the block diagrams and flow diagrams. Accordingly, the block diagrams and flow diagrams support various combinations of embodiments for performing the specified instructions, operations, or steps.

In addition, a feature of embodiments of the present disclosure may be combined or combined with one or more other features, partially or entirely, and may be operated in various ways, and an embodiment may be implemented independently of one or more other embodiments, or in conjunction with the one or more other embodiments.

Clock signals are used in electronic circuits to provide a timing reference for coordinating and/or synchronizing the operation of various components in a circuit. A clock signal may be initially calibrated to be synchronized with a data signal. However, during runtime, the clock signal may drift out of phase from the data signal due to the effects of power supply voltage (102) and temperature variations in the circuit, among other variations. For example, the data signal path and the clock signal path may be on different power supplies and thus experience different voltage-dependent characteristics, such as propagation delay, timing variations, sensitivity to noise, among others. Temperature variations across the circuit and/or components may affect the behavior of semiconductors materials and cause variations in speed, affecting timing.

Electronic circuits may also be susceptible to jitter, which may add unpredictable variations in the timing of a signal. In addition to phase shift, the clock signal may also be affected by jitter. In some cases, the presence of jitter may obscure the observation of phase shift, thus complicating accurate detection and compensation of phase drift.

Embodiments of the present disclosure are directed to systems, methods, and techniques for detecting and compensating for drift of a clock signal in the potential presence of jitter. A circuit may include a data signal, track signal, and clock signal. The clock signal and the track signal may be generated by the same clock source and initially calibrated to be synchronized with the data signal. In some embodiments, the track signal path and the data signal path may share the same power supply and be relatively close to each other on the circuit. As such, the track signal and the data signal may be assumed to remain synchronized, or relatively closer to being synchronized when compared to a circuit where the track signal path and the data signal path have different power supplies and/or are relatively far from each other. The track signal may serve as a representation of the timing of the data signal. Phase shift in the clock signal with respect to the data signal may be determined by determining phase shift between the clock signal and the track signal.

In some embodiments, a value of the track signal (e.g., 0 or 1) at a clock edge of the clock signal is used to make a determination of the clock signal status. The clock signal status may indicate whether the clock signal is leading, lagging, or aligned to the track signal. For example, the track signal may have a first value at a first clock edge, a second value at a second clock edge, and so on, for one or more samples.

In some embodiments, a sum of one or more of the track signal values is determined and compared to a reference value to determine the clock signal status. The reference value may be based on the number of sampled track signal values included in the sum. In an example in which each sampled track signal value may be 0 or 1, the reference value may be the number of samples in the sum divided by two. In some embodiments, the sum of the track signal values being equal to the reference value is used as an indicator that the clock signal may be aligned with the track signal. In some embodiments, the sum of the track signal values being greater than the reference value is used as an indicator that the clock signal may be lagging, and the sum being less than the reference value is used as an indicator that the clock signal may be leading. In some embodiments, the sum of the track signal values being greater than the reference value is used as an indicator that the clock signal may be leading, and the sum being less than the reference value is used as an indicator that the clock signal may be lagging.

In some embodiments, the clock signal is a multi-phase clock signal, which generates multiple clock signals having different phase offsets, such as 90° or 180° phase differences. The multiple clock signals may be used to determine whether the clock signal is overall leading, lagging, or aligned to the track signal. Values of the track signal at respective clock edges of the multiple clock signals may be used to make a determination of the clock signal status (e.g., whether the clock signal is leading, lagging, or aligned to the track signal). An individual clock signal of the multiphase clock signals can have a leading, lagging, or aligned status.

In some embodiments, the overall determination of the clock signal status is based on a majority poll of two or more (e.g., all) of the individual clock signals. For example, the clock signal may be determined to be leading if a majority of the multi-phase clock signals exhibit a leading status. If there is no majority (e.g., same number of clock signals have leading status and lagging status), the clock signal may be determined to be aligned overall.

The clock signal may be adjusted based on whether it is determined to be leading or lagging to the track signal. For example, the clock signal delay may be increased if the clock signal is leading with respect to the track signal and decreased if the clock signal is lagging with respect to the track signal. In some examples, the clock signal delay may be adjusted by a preset unit amount. Continuous feedback and adjustment of the clock signal may occur during runtime, at a preset frequency, or based on one or more triggers or conditions.

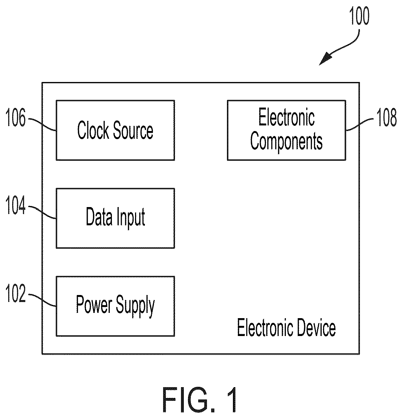

Fig. 1 depicts a block diagram of an electronic device 100 with clock signal shift mitigation, according to one or more embodiments. The electronic device 100 may include one or more power supplies 102, one or more data inputs 104, a clock source 106, and one or more electronic components 108. The one or more electronic components 108 may include one or more dies, integrated circuits, printed circuit boards, individual circuit components, among other forms of circuity.

In some embodiments, the one or more power supplies (also referred to as voltage supplies) 102 provide the supply voltage or positive voltage rail in the electronic circuit of the electronic device 100. The one or more power supplies 102 may power the clock source 106 and/or one or more of the electronic components 108. For example, the one or more power supplies 102 may supply the power used for controlling logic gates, enabling transistor switching, signal amplification or, and the like. In some embodiments, different voltage supplies 102 may power different components of the electronic components 108.

The one or more data inputs 104 may receive one or more data signals generated at the electronic device 100 or from another device. The clock source 106 may include a crystal oscillator, a clock generator IC, a phase-locked loop (PLL), an external clock source from a communication interface, an on-chip RC oscillator, or an internal processor/FPGA clock generator, among others.

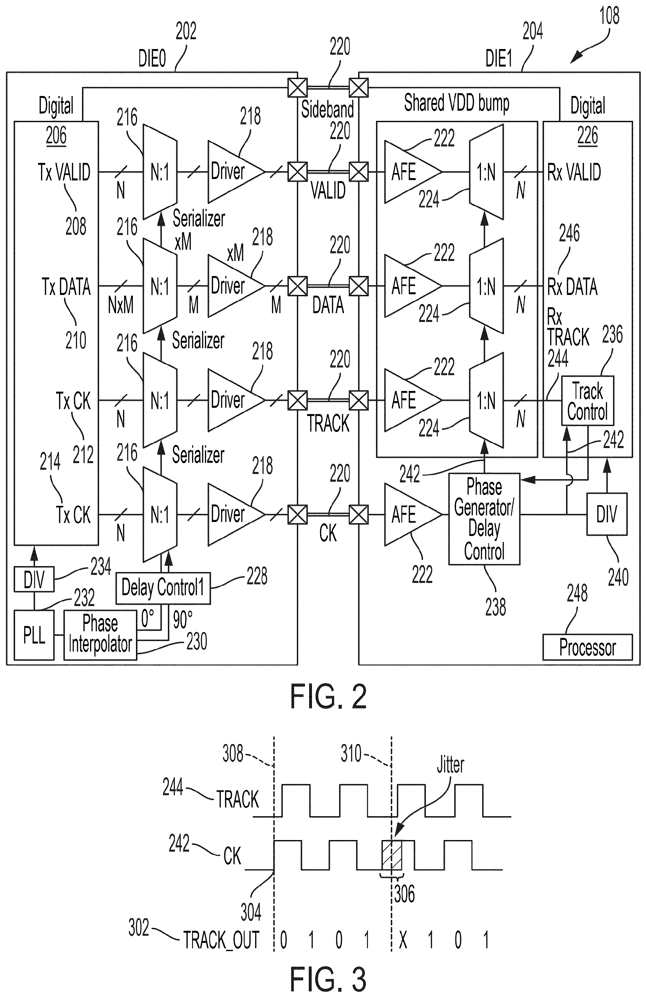

Fig. 2 depicts a block diagram of an example of the electronic components 108 of Fig. 1, according to one or more embodiments. In some embodiments, the electronic components 108 include a first die 202 and a second die 204 connected by one or more interconnects 220. In some embodiments, the first die 202 serves as a transmitter side die and the second die 204 serves as a receiver side die. The first die 202 may include a digital block 206, which includes a transmission side of a valid signal 208, a data signal 210, a clock tracking signal (also referred to as a track signal) 212, and a clock signal 214. In some embodiments, the valid signal 208, the data signal 210, the track signal 212, and the clock signal 214 are fed into respective serializers 216 and respective drivers 218 and transmitted to the second die 204 via respective interconnects 220.

In some embodiments, the first die 202 includes a phase-locked loop (PLL) 232, a phase interpolator 230, a divider 234, and a first clock signal delay controller 228. The PLL 232 may receive a reference signal from the clock source 106 and generate an output clock signal whose phase may be fixed relative to the phase of the reference signal. The PLL 232 may continuously or periodically (e.g., on a regular or irregular basis) adjust the phase of the generated clock signal to match the reference clock signal.

In some embodiments, the phase interpolator 230 generates multiple clock phases based on the clock signal generated by the PLL 232. The phase interpolator 230 may generate multi-phase clock signals that are offset by a specified amount. (e.g. 90°, 180°). For example, the phase interpolator 230 may generate four equally spaced clock phases, (also referred to as a four-phase clock signal) from the clock signal generated by the PLL 232. A four-phase clock signal may also be understood to have four individual clock signals offset by equally spaced clock phases.

In some embodiments, the divider 234 reduces the frequency of the clock signal by a certain factor. The reduction of the frequency may be used to create slower clock signals for subsystems or to provide clock signals that are required for timing-critical tasks at different stages in the circuit. In some embodiments, the clock delay controller 228 is utilized to adjust the timing of the clock signal by introducing a delay or units of delay. The adjustment of the timing of the clock signal may help establish or maintain synchronization between the clock signal 214 and the data signal 210. In some embodiments, the track signal 212 is a copy of the clock signal 214, also synchronized with the data signal 210.

In some embodiments, the second die 204 may receive one or more of the valid signal 208, the data signal 210, the track signal 212, and the clock signal 214. The second die 204 may feed the received signals 208-214 into respective analog front-end (AFE) amplifiers 222. In some embodiments, the valid signal 208, the data signal 210, and the track signal 212 are fed into respective deserializers 224 and received at a digital block 226 of the second die 204. In the embodiment depicted in Fig. 2, the data signal received at the digital block 226 of the second die 204 is denoted as data signal 246, the track signal received at the digital block 226 of the second die 204 is denoted as track signal 244, and the clock signal received at the digital block 226 of the second die 204 is denoted as clock signal 242.

In some embodiments, the AFE amplifiers 222 and deserializers 224 of the valid signal, the data signal, and the track signal share a voltage supply (not shown). In some embodiments, the path of the track signal 244 and the path of the data signal 246 may also be relatively closer to each other compared to the path of the clock signal 242. The track signal 244 and the data signal 246 may be assumed to remain synchronized, or relatively closer to being synchronized than the clock signal 242 and the data signal 246. In some embodiments, the track signal 244 may serve as a representation of the timing of the data signal 246. In some cases, although the clock signal 214 and the track signal 212 may be generated by the same source and both initially calibrated to be synchronized with the data signal 210 at the first die 202, the clock signal 242 may fall out of synchronization with respect to the data signal 246 when it reaches the digital block 226 of the second die 204. The phase shift of the clock signal 242 with respect to the data signal 246 may be determined by identifying phase shift between the clock signal 242 and the track signal 244.

In some embodiments, the second die 204 includes a track controller 236 configured to receive as inputs the track signal 244 and the clock signal 242 at the second die 204, and determine a command (hereinafter referred to as a delay control command) to delay or advance the clock signal 242 at the second die 204. In some embodiments, the second die 204 may include a phase generator or delay controller 238 that configured to receive the delay control command from the track controller 236 and adjust the clock signal 242 accordingly. For example, if the track controller 236 determines that the clock signal 242 is leading with respect to the track signal 244, the delay controller 238 may delay the clock signal 242 by a certain amount, such as one or more unit intervals. If the track controller 236 determines that the clock signal 242 is lagging with respect to the track signal 244, the delay controller 238 may advance the clock signal 242 by a certain amount. Continuous or periodic feedback and adjustment of the clock signal 242 may occur during runtime, at a preset frequency, or based on one or more triggers or conditions.

In some embodiments, track controller 236 includes one or more settings and/or parameters for determining the status of the clock signal and/or controlling the delay controller 238. In some embodiments, an enable signal fed to the track controller 236 allows the track controller 236 to be turned on or off. The one or more parameters of the track controller 236 may include a number of samples (N) of the tracking signal (also referred to as a track duration) to take and utilize in determining the delay control command. In some embodiments, the track controller 236 may receive such settings or parameters, such as the enable signal and the track duration, from a processor 248.

Fig. 3 depicts a timing diagram of the clock signal 242 in the presence of jitter, according to one or more embodiments. Phase shift in the clock signal 242 with respect to the data signal 246 may be determined by determining phase shift between the clock signal 242 and the track signal 244. In some embodiments, a value 302 of the track signal 244 (e.g., 0 or 1) at a clock edge 304 of the clock signal 242 is used to make a determination of a clock signal status. The clock signal status may indicate whether the clock signal 242 is leading, lagging, or aligned with respect to the track signal 244. For example, at clock edge 304, the value 302 of the track signal 244 is 0. Clock edge 304 also occurs at the expected time 308. However, in the presence of jitter, a clock edge may occur unexpectedly earlier or later than the expected time 310, anywhere within in the representative clock edge window 306. Window 306 is provided for illustrative purposes, and there may not be a discrete window of time in which jitter may occur. Jitter may also occur unpredictably at any clock edge, which may result in the sampled value 302 of the track signal 244 at clock edges potentially being an inaccurate representation with respect to phase shift of the clock signal 242.

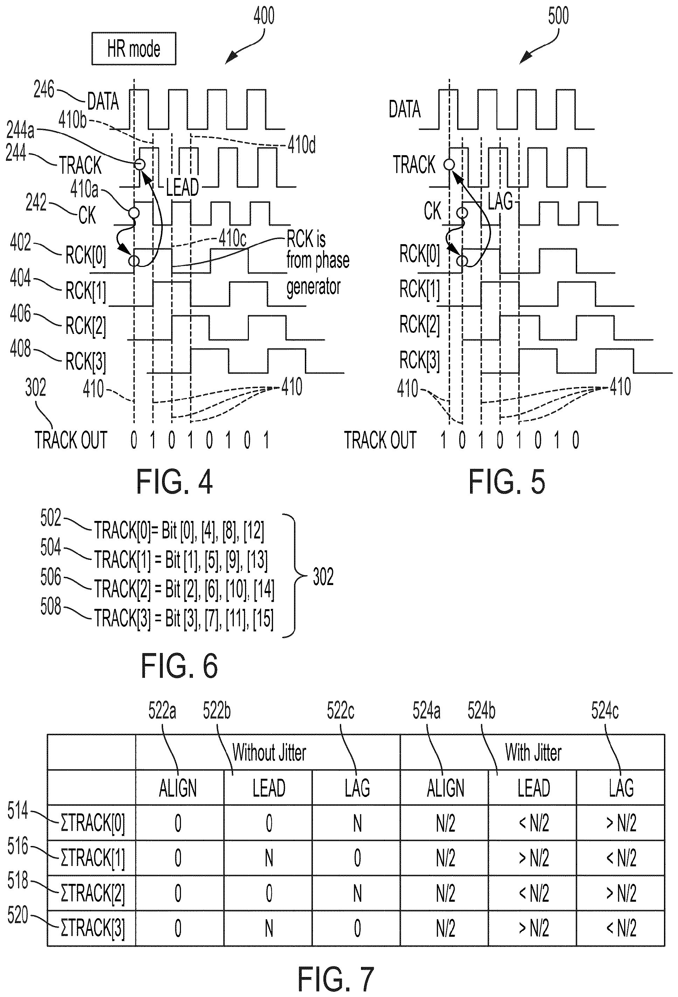

Fig. 4 depicts a timing diagram 400 associated with the clock signal 242 in half-rate mode exhibiting a leading phase shift with respect to the track signal 244, and Fig. 5 a timing diagram 500 associated with the clock signal 242 in half-rate mode exhibiting a lagging phase shift with respect to the track signal 244, according to one or more embodiments. In some embodiments, the track signal value 302 may be sampled at one or more clock edges 410 of the clock signal 242, and a sum of the track signal values 302 may be used as an indicator of the status of the clock signal 242 (e.g., whether the clock signal is leading, lagging, or aligned with respect to the track signal 244). For example, the clock edge 410a leads a track signal edge 244a, and the sampled value 302 of the track signal at clock edge 410a is low and takes a value of 0. Similarly, the sampled value 302 of the track signal at clock edge 410c is 0. The track signal at clock edges 410b and 410d is high and takes a value of 1.

In some embodiments, the sum of the sampled values 302 of the track signal may be compared to a reference value to determine the status of the clock signal 242 as leading, lagging, or aligned. In some embodiments, the sampled track signal values 302 may be associated with one or more groups, also referred to as tracks.

FIG. 6 depicts a schematic representation of example tracks 502, 504, 506, 508 where track signal values 302 are sampled at respective clock edges, also referred to as bits. In the example of FIG. 6, track values are sampled at four clock edges, although embodiments are not limited thereto. For example, a first track 502 may include the track signal values 302 at the first, fifth, ninth, and thirteenth clock edges (or Bit [0], Bit [4], Bit [8], Bit [12]) of the clock signal 242. A second track 504 may include the track signal values 302 at the second, sixth, tenth, and fourteenth clock edges (or Bit [1], Bit [5], Bit [9], Bit [13]) of the clock signal 242. A third track 506 may include the track signal values 302 at the third, seventh, eleventh, and fifteenth clock edge (or Bit [2], Bit [6], Bit [10], Bit [14]) of the clock signal 242. A fourth track 508 may include the track signal values 302 at the fourth, eighth, twelfth, and sixteenth clock edge (or Bit [3], Bit [7], Bit [11], Bit [15]) of the clock signal 242. In some embodiments, there may be fewer or more than four tracks and fewer or more than four samples per track.

The sum of the track signal values 302 of an individual track (e.g., 502, 504, 506, 508) taken at the clock edges may be used to make a determination of the status of the clock signal, such as whether the clock edges at which the individual track is sampled indicates a leading, lagging, or aligned clock signal status with respect to the track signal 244. The clock signal status provided by an individual track may be determined by comparing the sum of the track signal values 302 to a reference value.

Fig. 7 depicts a table of expected sum of track signal values 514-520 for the tracks 502-508 identified in FIG. 6, to determine a first clock signal status 522a-522c (collectively referenced as 522) where the clock signal does not encounter jitter, and for determining a second clock signal status 524a-524c (collectively referenced as 524) where the clock signal experiences jitter. In some embodiments, the clock signal status 522, 524 is computed based on a sum of the corresponding track signal values 302. In some embodiments, the reference value that is used to compare against the sum of the track values to determine the status of the clock signal is based on the number of samples (track signal values) (N) included in the summation. The number of samples that are included in the summation is based on a track duration which may be set, for example, by the processor 248, and provided to the track controller 236 as an input parameter. In the example of Fig. 5, where there are four samples in an individual track (e.g., 502, 504, 506, 508), the value of N is four.

Taking tracks 0 and 2 as an example, the sum of track values 514, 518 is equal to the reference value (N) when the clock signal is lagging without any jitter, given that the track signal will have a value of 1 when sampling at Bit [0], Bit [4], Bit [8], and Bit [12]for track 0, and when sampling at Bit [2], Bit [6], Bit [10], and Bit [14]for track 2. For tracks 1 and 3, the sum of track values 516, 520 is equal to the reference value (N) when the clock signal is leading without any jitter.

In some embodiments, in the presence of potential jitter, the sum of the corresponding track values being N/2 may be used as an indication that the clock signal is aligned with respect to the track signal. For example, when the clock signal is aligned with the track signal but jitter occurs, the sampled track signal may randomly take a value of 0 or 1. An average of the possible track values at a corresponding clock edge is computed for N samples, resulting in the reference value of N/2 in the presence of potential jitter.

In some embodiments, in the presence of potential jitter, the sum of the first track values 514 being less than the computed average reference value (N/2) may be used as an indication that the clock signal is leading with respect to the track signal. In some embodiments, in the presence of potential jitter, the sum of the first track values 514 being greater than the computed average reference value (N/2) may be used as an indication that the clock signal is lagging with respect to the track signal.

In some embodiments, in the presence of potential jitter, the sum of the second track values 516 being greater than the computed average reference value (N/2) may be used as an indication that the clock signal is leading with respect to the track signal. In some embodiments, in the presence of potential jitter, the sum of the second track values 516 being less than the computed average reference value (N/2) may be used as an indication that the clock signal is lagging with respect to the track signal.

In some embodiments, in the presence of potential jitter, the sum of the third track values 518 being less than the computed average reference value (N/2) may be used as an indication that the clock signal is leading with respect to the track signal. In some embodiments, in the presence of potential jitter, the sum of the third track values 518 being greater than the computed average reference value (N/2) may be used as an indication that the clock signal is lagging with respect to the track signal.

In some embodiments, in the presence of potential jitter, the sum of the fourth track values 520 being greater than the computed average reference value (N/2) may be used as an indication that the clock signal is leading with respect to the track signal. In some embodiments, in the presence of potential jitter, the sum of the fourth track values 520 being less than the computed average reference value (N/2) may be used as an indication that the clock signal is lagging with respect to the track signal.

In the example of Fig. 6, there are four samples in an individual track (e.g., 502, 504, 506, 508). Thus, the reference value is N/2 = 2 in the presence of potential jitter. In some embodiments, the reference value may be designated based on a different function. In some embodiments, the reference value is designated based on the value associated with the aligned status, and whether a track is leading or lagging is based on whether the sum is greater than or less than the value associated with the aligned status.

In some embodiments, the overall determination of the clock signal status is based on a majority poll of two or more (e.g., all) of the individual tracks (e.g., 502, 504, 506, 508). For example, the clock signal may be determined to be leading if a majority of the individual tracks (e.g., 502, 504, 506, 508) indicate a leading status. If there is no majority (e.g., same number of individual tracks indicate a leading status and lagging status), the clock signal 242 may be determined to be aligned overall.

The clock signal 242 may be adjusted based on whether it is determined to be leading or lagging to the track signal 244. For example, if the clock signal 242 is leading with respect to the track signal 244, the track controller 236 may send a command to the delay controller 238 to add additional delay to the clock signal 242. If the clock signal 242 is lagging with respect to the track signal 244, the track controller 236 may send a command to the delay controller 238 to advance the clock signal 242. The clock signal 242 may be delayed or advanced by one or more a predetermined unit intervals or by a custom amount.

Referring to Figs. 4 and 5, in some embodiments, the clock signal 242 is a four-phase clock signal and includes a first phase clock signal 402, a second phase clock signal 404, a third phase clock signal 406, and a fourth phase clock signal 408. The second phase clock signal 404 may be offset from the first phase clock signal 402 by 90°. The third phase clock signal 406 may be offset from the first phase clock signal 402 by 180°. The fourth phase clock signal 408 signal may be offset from the first phase clock signal 402 by 270°. The four tracks 502, 504, 506, 508 may be based on these four clock signals. In some embodiments, a first clock edge of the first phase clock signal 402 may correspond to a first clock edge of the clock signal 242, a first clock edge of the second phase clock signal 404 may correspond to a second clock edge of the clock signal 242, a first clock edge of the third phase clock signal 406 may correspond to a third clock edge of the clock signal 242, and a first clock edge of the fourth phase clock signal 408 may correspond to a fourth clock edge of the clock signal 242.

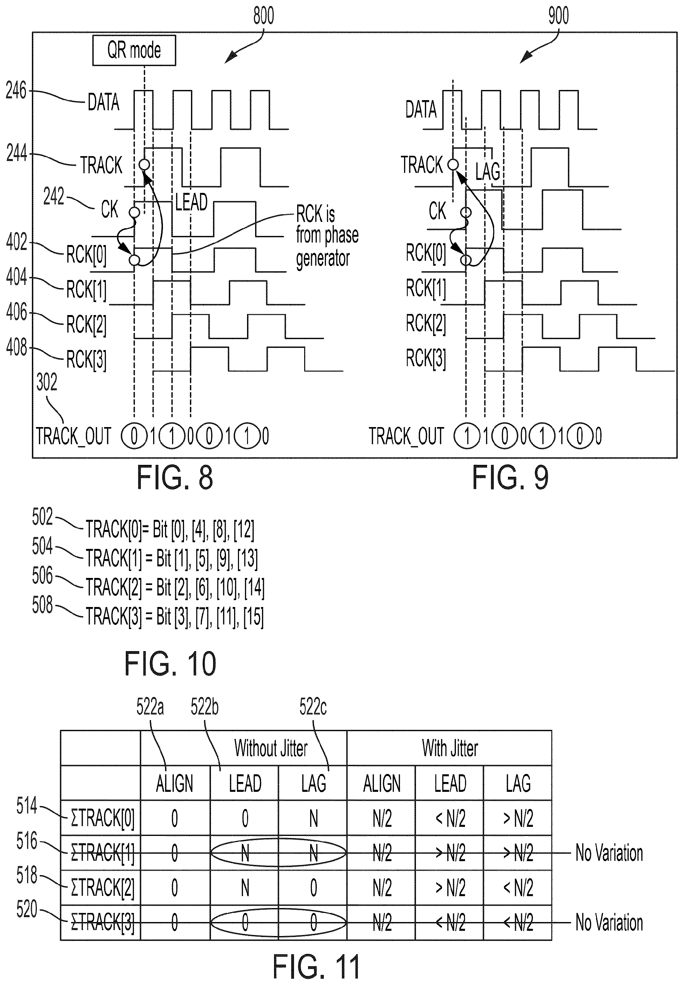

Fig. 8 depicts a timing diagram 800 associated with a clock signal 242 in quarter-rate mode exhibiting a leading phase shift with respect to a track signal 244, according to one or more embodiments. Fig. 9 depicts a timing diagram 900 associated with the clock signal 242 in quarter-rate mode exhibiting a lagging phase shift with respect to the track signal 244, according to one or more embodiments. In the quarter-rate mode, the clock signal 242 and track signal 244 have half the rate or frequency of the data signal 246. Fig. 10 depicts a schematic representation of an example of four tracks 502, 504, 506, 508 where track signal values 302 are sampled at respective clock edges, also referred to as bits.

Fig. 11 depicts a table of expected sum of track signal values 514-520 for the tracks 502-508 identified in Fig. 10 to determine a first clock signal status 522a-522c (collectively referenced as 522) where the clock signal does not encounter jitter, and for determining a second clock signal status 524a-524c (collectively referenced as 524) where the clock signal experiences jitter, when the clock signal is in quarter-rate mode. In some embodiments, the technique is similar to that described above with reference to Fig. 7 where the clock signal is in half-rate mode. However, in some embodiments, in the quarter-rate mode, the leading status 522b and the lagging status 522c of the second track 504 without jitter may be indistinguishable based on the sum of the track signal value 516. In some embodiments, in the quarter-rate mode, the leading status 522b and the lagging status 522c of the fourth track 508 without jitter may be indistinguishable based on the sum of the track signal value 520. In some embodiments, these values are not used in evaluating the clock signal status when the clock signal is in the quarter-rate mode.

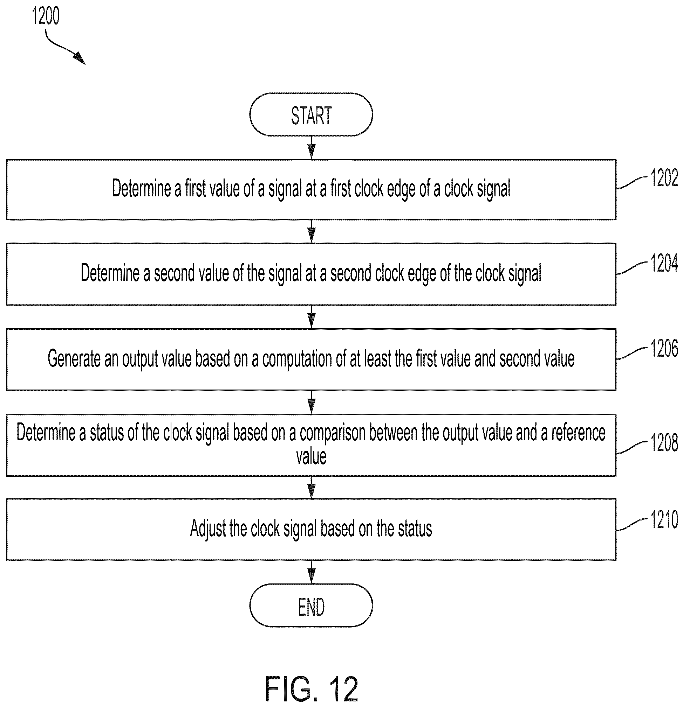

Fig. 12 depicts a flow diagram of a process 1200 for detecting and mitigating clock signal drift, according to one or more embodiments. The process 1200 starts, and at operation 1202, the track controller 236 determines a first value of a signal (e.g., track signal 244) at a first clock edge of a clock signal 242. At operation 1204, the track controller 236 determines a second value of the signal (e.g., track signal 244) at a second clock edge of the clock signal 242.

At operation 1206, the track controller 236 generates an output value based on a computation of at least the first value and second value. In some embodiments, the output value is a sum of the first value and second value. In some embodiments, the output value is an average of the first value and second value. In some embodiments, the output value is a mode of the first value and second value.

At operation 1208, the track controller 236 determines a status of the clock signal based on a comparison between the output value and a reference value. The reference value may be based on the number of sampled track signal values included in the output value. In an example in which each sampled track signal value may be 0 or 1, the reference value may be the number of samples in the output value divided by two. In some embodiments, the output value of the track signal values being equal to the reference value is used as an indicator that the clock signal may be aligned with the track signal. In some embodiments, the output value of the track signal values being greater than the reference value is used as an indicator that the clock signal may be lagging, and the output value being less than the reference value is used as an indicator that the clock signal may be leading. In some embodiments, the output value of the track signal values being greater than the reference value is used as an indicator that the clock signal may be leading, and the output value being less than the reference value is used as an indicator that the clock signal may be lagging.

At operation 1210, the track controller 236 may adjust the clock signal based on the determined status. For example, the track controller 236 may send a command to the delay controller 238 to delay the clock signal based on the status of the clock signal being leading with respect to the track signal. The track controller 236 may send a command to the delay controller 238 to advance the clock signal based on the status of the clock signal being lagging with respect to the track signal.

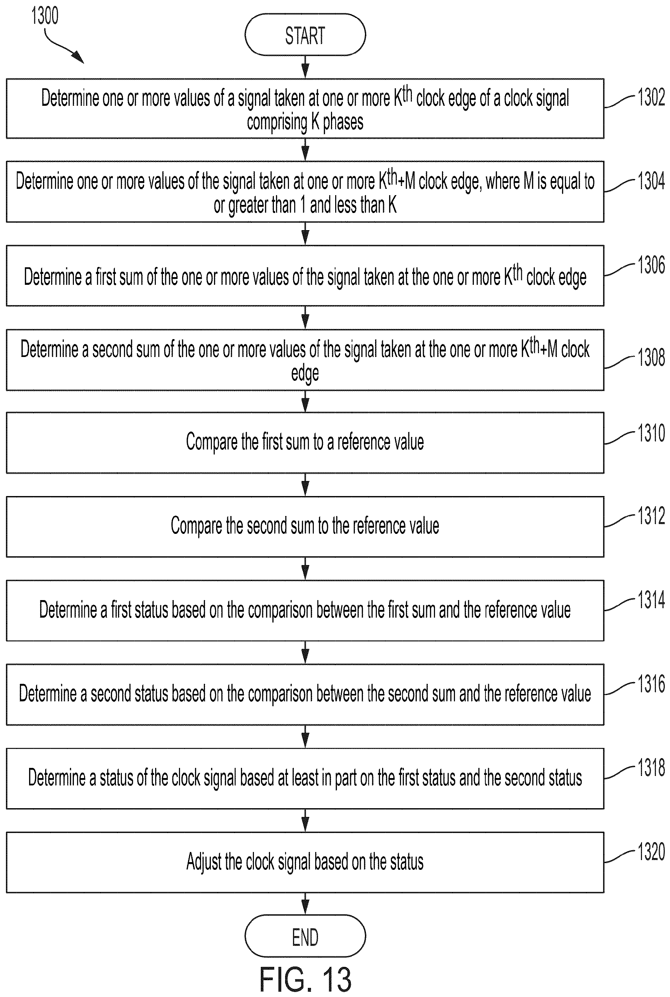

Fig. 13 depicts a flow diagram of a process 1300 for detecting and mitigating clock signal drift for a multi-phase clock signal, according to one or more embodiments.

The process 1300 starts, and at operation 1302, the track controller 236 may determine one or more values of a signal (e.g., track signal) taken at one or more Kth clock edge of a clock signal having K phases. At operation 1304, the track controller 236 may determine one or more values of the signal taken at one or more K^{th}+M clock edge, where M is equal to or greater than 1 and less than K.

At operation 1306, the track controller 236 may determine a first sum of the one or more values of the signal taken at the one or more K^{th} clock edge. At operation 1308, the track controller 236 may determine a second sum of the one or more values of the signal taken at the one or more K^{th}+M clock edge.

At operation 1310, the track controller 236 may compare the first sum to a reference value. At operation 1312, the track controller 236 may compare the second sum to the reference value.

At operation 1314, the track controller 236 may determine a first status based on the comparison between the first sum and the reference value. The first status may be that the first sum indicates that the clock signal is leading, lagging, or aligned with respect to the track signal. At operation 1316, the track controller 236 may determine a second status based on the comparison between the second sum and the reference value. The second status may be that the second sum indicates that the clock signal is leading, lagging, or aligned with respect to the track signal.

At operation 1318, the track controller 236 may determine a status of the clock signal based at least on the first status and the second status. In some embodiments, the status of the clock signal may be that the clock signal is leading with respect to the track signal based on a majority of at least the first status and the second status being leading with respect to the track signal. In some embodiments, the status of the clock signal may be that the clock signal is lagging with respect to the track signal based on a majority of at least the first status and the second status being lagging with respect to the track signal. Otherwise (e.g., if there is no majority), the status of the clock signal may be that the clock signal is aligned with respect to the track signal.

At operation 1320, the track controller 236 may adjust the clock signal based on the status. For example, the track controller 236 may send a command to the delay controller 238 to delay the clock signal based on the status of the clock signal being leading with respect to the track signal. The track controller 236 may send a command to the delay controller 238 to advance the clock signal based on the status of the clock signal being lagging with respect to the track signal.

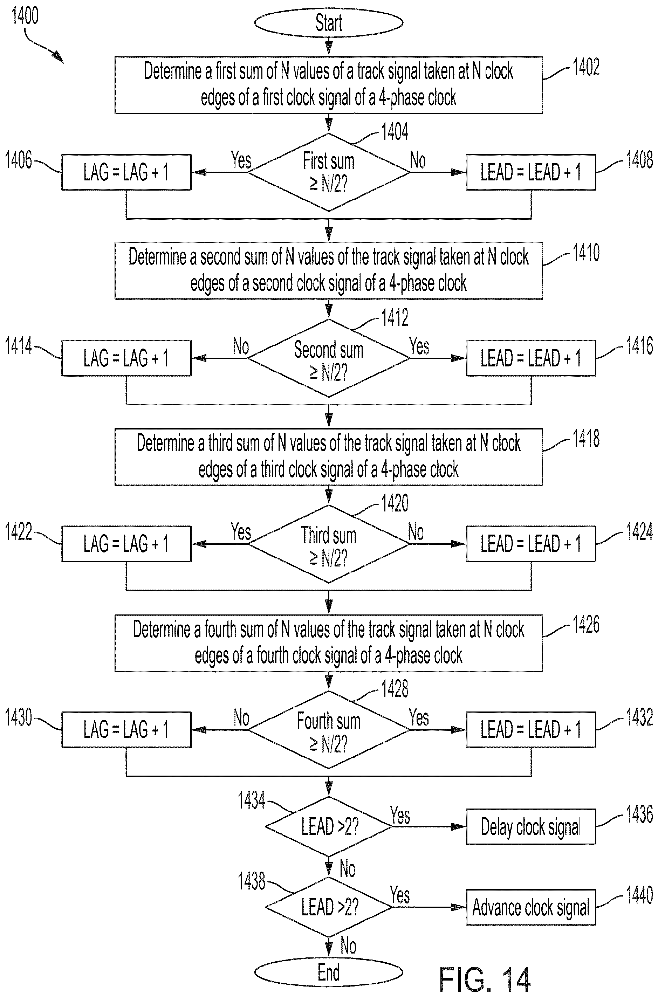

Fig. 14 depicts a flow diagram of a process 1400 for detecting and mitigating clock signal drift for a four-phase clock signal in half-rate mode, according to one or more embodiments. The process 1400 starts, and at operation 1402, the track controller 236 may determine a first sum of N values of a track signal taken at N clock edges of a first clock signal of a 4-phase clock signal. In some embodiments, a lag counter is set at zero and a lead counter is set at zero. At operation 1404, the track controller 236 determines if the first sum is greater than or equal to reference value N/2. If the first sum is greater than the reference value N/2, the process 1400 proceeds to operation 1406. If the first sum is not greater than or equal to N/2, the process 1400 proceeds to operation 1408. At operation 1406, the lag counter is increased by one. At operation 1408, the lead counter is increased by one.

At operation 1410, the track controller 236 may determine a second sum of N values of the track signal taken at N clock edges of a second clock signal of the 4-phase clock signal. At operation 1412, the track controller 236 determines if the second sum is greater than or equal to reference value N/2. If the second sum is greater than the reference value N/2, the process 1400 proceeds to operation 1416. If the second sum is not greater than or equal to N/2, the process 1400 proceeds to operation 1414. At operation 1414, the lag counter is increased by one. At operation 1416, the lead counter is increased by one.

At operation 1418, the track controller 236 may determine a third sum of N values of the track signal taken at N clock edges of a third clock signal of the 4-phase clock signal. At operation 1420, the track controller 236 determines if the third sum is greater than or equal to reference value N/2. If the third sum is greater than the reference value N/2, the process 1400 proceeds to operation 1422. If the third sum is not greater than or equal to N/2, the process 1400 proceeds to operation 1424. At operation 1422, the lag counter is increased by one. At operation 1424, the lead counter is increased by one.

At operation 1426, the track controller 236 may determine a fourth sum of N values of the track signal taken at N clock edges of a fourth clock signal of the 4-phase clock signal. At operation 1428, the track controller 236 determines if the second sum is greater than reference value N/2. If the second sum is greater than or equal to the reference value N/2, the process 1400 proceeds to operation 1432. If the first sum is not greater than or equal to N/2, the process 1400 proceeds to operation 1430. At operation 1430, the lag counter is increased by one. At operation 1432, the lead counter is increased by one.

In some embodiments, at operation 1434, the track controller 236 determines if the lead counter is greater than two. If the lead counter is greater than two, the process 1400 proceeds to operation 1436 and the track controller 236 delays the clock signal 242. If the lead counter is not greater than two, the process 1400 proceeds to operation 1438, wherein the track controller 236 determines if the lag counter is greater than two. If the lag counter is greater than two, the process 1400 proceeds to operation 1440 and the track controller 236 advances the clock signal 242. If the lag counter is not greater than two, the process 1400 ends.

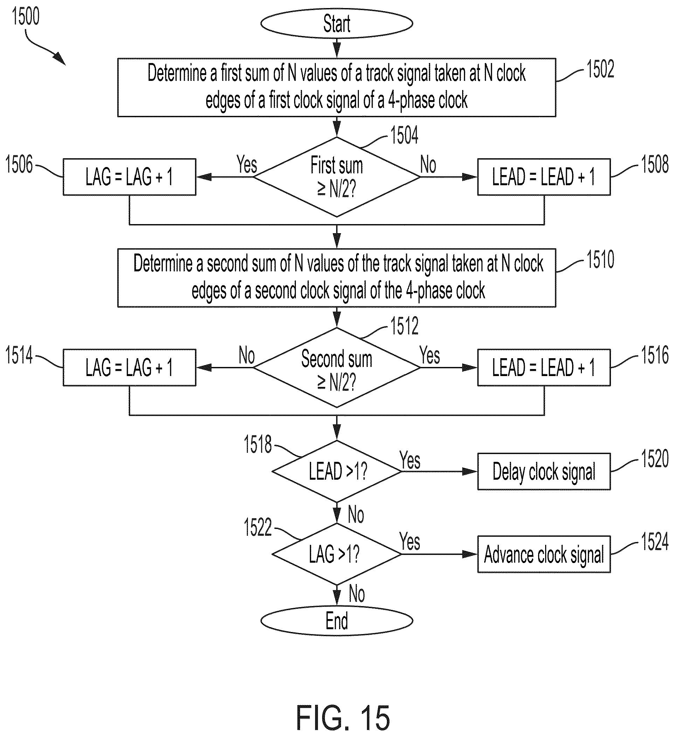

Fig. 15 depicts a flow diagram of a process 1500 for detecting and mitigating clock signal drift for a four-phase clock signal in quarter-rate mode, according to one or more embodiments. As illustrated in Fig. 7, in the quarter-rate mode, there is no distinction between the summation values of the second track 516 for leading and lagging status and there is no distinction between the summation values of the fourth track 516 for leading and lagging status. These values are not considered in evaluating the overall status of the clock signal. Thus, in the process 1500 of Fig. 15, the summation of the third track is referred to as the second sum.

The process 1500 starts, and at operation 1502, the track controller 236 may determine a first sum of N values of a track signal taken at N clock edges of a first clock signal of a 4-phase clock signal. In some embodiments, a lag counter is set at zero and a lead counter is set at zero. At operation 1504, the track controller 236 determines if the first sum is greater than or equal to reference value N/2. If the first sum is greater than the reference value N/2, the process 1500 proceeds to operation 1506. If the first sum is not greater than or equal to N/2, the process 1500 proceeds to operation 1508. At operation 1506, the lag counter is increased by one. At operation 1508, the lead counter is increased by one.

At operation 1510, the track controller 236 may determine a third sum of N values of the track signal taken at N clock edges of a third clock signal of the 4-phase clock signal. At operation 1512, the track controller 236 determines if the third sum is greater than or equal to reference value N/2. If the third sum is greater than the reference value N/2, the process 1500 proceeds to operation 1516. If the third sum is not greater than or equal to N/2, the process 1500 proceeds to operation 1514. At operation 1514, the lag counter is increased by one. At operation 1516, the lead counter is increased by one.

In some embodiments, at operation 1518, the track controller 236 determines if the lead counter is greater than one. If the lead counter is greater than one, the process 1500 proceeds to operation 1520 and the track controller 236 delays the clock signal 242. If the lead counter is not greater than one, the process 1500 proceeds to operation 1522, where the track controller 236 determines if the lag counter is greater than one. If the lag counter is greater than 1, the process 1500 proceeds to operation 1524 and the track controller 236 advances the clock signal 242. If the lag counter is not greater than one, the process 1500 ends.

Embodiments of the present disclosure improve the function of electronic system at least by enabling more accurate detection and compensation of phase drift of a clock signal in a circuit in the presence of jitter. Without the techniques of the present disclosure, jitter may hide the presence of phase drift or falsely indicate phase drift. The techniques of the present disclosure make the observation of phase drift more robust against the presence of jitter in a clock signal.

One or more embodiments of the present disclosure may be implemented in one or more processors. The term processor may refer to one or more processors and/or one or more processing cores. The one or more processors may be hosted in a single device or distributed over multiple devices (e.g. over a cloud system). A processor may include, for example, application specific integrated circuits (ASICs), general purpose or special purpose central processing units (CPUs), digital signal processors (DSPs), graphics processing units (GPUs), and programmable logic devices such as field programmable gate arrays (FPGAs). In a processor, as used herein, each function is performed either by hardware configured, i.e., hard-wired, to perform that function, or by more general-purpose hardware, such as a CPU, configured to execute instructions stored in a non-transitory storage medium (e.g. memory). A processor may be fabricated on a single printed circuit board (PCB) or distributed over several interconnected PCBs. A processor may contain other processing circuits; for example, a processing circuit may include two processing circuits, an FPGA and a CPU, interconnected on a PCB.

It will be understood that, although the terms "first", "second", "third", etc., may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed herein could be termed a second element, component, region, layer or section, without departing from the spirit and scope of the inventive concept.

The terminology used herein is for the purpose of describing particular embodiments only and is not intended to be limiting of the inventive concept. Also, unless explicitly stated, the embodiments described herein are not mutually exclusive. Aspects of the embodiments described herein may be combined in some implementations.

As used herein, the terms "substantially," "about," and similar terms are used as terms of approximation and not as terms of degree, and are intended to account for the inherent deviations in measured or calculated values that would be recognized by those of ordinary skill in the art.

As used herein, the singular forms "a" and "an" are intended to include the plural forms as well, unless the context clearly indicates otherwise. It will be further understood that the terms "comprises" and/or "comprising", when used in this specification, specify the presence of stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. Expressions such as "at least one of," when preceding a list of elements, modify the entire list of elements and do not modify the individual elements of the list. Further, the use of "may" when describing embodiments of the inventive concept refers to "one or more embodiments of the present disclosure". Also, the term "exemplary" is intended to refer to an example or illustration. As used herein, the terms "use," "using," and "used" may be considered synonymous with the terms "utilize," "utilizing," and "utilized," respectively.

Although exemplary embodiments of systems and methods for mitigating clock signal shift have been specifically described and illustrated herein, many modifications and variations will be apparent to those skilled in the art. Accordingly, it is to be understood that systems and methods for mitigating clock signal shift constructed according to principles of this disclosure may be embodied other than as specifically described herein. The disclosure is also defined in the following claims.

The systems and methods for mitigating clock signal drift may contain one or more combination of features set forth in the below statements.

Statement 1: A method comprising: determining a first value of a signal at a first clock edge of a clock signal; determining a second value of the signal at a second clock edge of the clock signal; generating an output value based on a computation of at least the first value and the second value; determining a status of the clock signal based on a comparison between the output value and a reference value; and adjusting the clock signal based on the status.

Statement 2: In the method of Statement 1, wherein the determining the status includes identifying the clock signal as leading with respect to the signal, and wherein the adjusting of the clock signal includes increasing a delay of the clock signal.

Statement 3: In the method of any of Statements 1 or 2, wherein the determining the status includes identifying the clock signal as lagging with respect to the signal, and wherein the adjusting of the clock signal includes advancing the clock signal.

Statement 4: In the method of any of Statements 1-3, wherein the computation includes at least one of a sum, average, or mode of at least the first value and the second value.

Statement 5: In the method of any of Statements 1-4, wherein the sum is based on a plurality of values taken at a plurality of clock edges, the plurality of values including the first value and the second value, and wherein the reference value is based on the number of values in the plurality of values.

Statement 6: In the method of any of Statements 1-5, wherein the reference value is based on the number of the values divided by two.

Statement 7: In the method of any of Statements 1-6, wherein the clock signal includes K number of phases, and the method further comprises: determining one or more values of the signal taken at one or more K^{th} clock edge; determining one or more values of the signal taken at one or more K^{th}+M clock edge, where M is equal to or greater than 1 and less than K; determining a first sum of the one or more values of the signal taken at the one or more K^{th} clock edge; determining a second sum of the one or more values of the signal taken at the one or more K^{th}+M clock edge; comparing the first sum to the reference value; comparing the second sum to the reference value; determining a first status based on the comparison between the first sum and the reference value; determining a second status based on the comparison between the second sum and the reference value; and determining the status of the clock signal based at least in part on the first status and the second status.

Statement 8: In the method of any of Statements 1-7, wherein the first status is one of leading, lagging, or aligned with respect to the signal, and wherein the second status is one of leading, lagging, or aligned with respect to the signal, and wherein the method further comprises: determining the status of the clock signal as leading with respect to the signal based on a majority of at least the first status and the second status being leading with respect to the signal.

Statement 9: In the method of any of Statements 1-8, wherein the first status is one of leading, lagging, or aligned with respect to the signal, and wherein the second status is one of leading, lagging, or aligned with respect to the signal, and wherein the method further comprises: determining the status of the clock signal as lagging with respect to the signal based on a majority of at least the first status and the second status being lagging with respect to the signal.

Statement 10: In the method of any of Statements 1-9, wherein the reference value is calculated based on an assumption of jitter in the clock signal.

Statement 11: A system comprising: a processing circuit; and a memory storing instructions, which, based on being executed by the processing circuit, cause the processing circuit to perform: determining a first value of a signal at a first clock edge of a clock signal; determining a second value of the signal at a second clock edge of the clock signal; generating an output value based on a computation of at least the first value and the second value; determining a status of the clock signal based on a comparison between the output value and a reference value; and adjusting the clock signal based on the status.

Statement 12: In the system of Statements 11, wherein the determining the status includes identifying the clock signal as leading with respect to the signal, and wherein the adjusting of the clock signal includes increasing a delay of the clock signal.

Statement 13: In the system of Statements 11 or 12, wherein the determining the status includes identifying the clock signal as lagging with respect to the signal, and wherein the adjusting of the clock signal includes advancing the clock signal.

Statement 14: In the system of any of Statements 11-13, wherein the computation includes at least one of a sum, average, or mode of at least the first value and the second value.

Statement 15: In the system of any of Statements 11-14, wherein the sum is based on a plurality of values taken at a plurality of clock edges, the plurality of values including the first value and the second value, and wherein the reference value is based on the number of values in the plurality of values.

Statement 16: In the system of any of Statements 11-15, wherein the reference value is based on the number of the values divided by two.

Statement 17: In the system of any of Statements 11-16, wherein the clock signal includes K number of phases, and the instructions, based on being executed by the processing circuit, further cause the processing circuit to perform: determining one or more values of the signal taken at one or more K^{th} clock edge; determining one or more values of the signal taken at one or more K^{th}+M clock edge, where M is equal to or greater than 1 and less than K; determining a first sum of the one or more values of the signal taken at the one or more K^{th} clock edge; determining a second sum of the one or more values of the signal taken at the one or more K^{th}+M clock edge; comparing the first sum to the reference value; comparing the second sum to the reference value; determining a first status based on the comparison between the first sum and the reference value; determining a second status based on the comparison between the second sum and the reference value; and determining the status of the clock signal based at least in part on the first status and the second status.

Statement 18: In the system of any of Statements 11-17, wherein the first status is one of leading, lagging, or aligned with respect to the signal, and wherein the second status is one of leading, lagging, or aligned with respect to the signal, and wherein the method further comprises: determining the status of the clock signal as leading with respect to the signal based on a majority of at least the first status and the second status being leading with respect to the signal.

Statement 19: In the system of any of Statements 11-18, wherein the first status is one of leading, lagging, or aligned with respect to the signal, and wherein the second status is one of leading, lagging, or aligned with respect to the signal, and wherein the method further comprises: determining the status of the clock signal as lagging with respect to the signal based on a majority of at least the first status and the second status being lagging with respect to the signal.

Statement 20: In the system of any of Statements 11-19, wherein the reference value is calculated based on an assumption of jitter in the clock signal.

## Claims

1. A method comprising:
determining a first value of a signal at a first clock edge of a clock signal;
determining a second value of the signal at a second clock edge of the clock signal;
generating an output value based on a computation of at least the first value and the second value;
determining a status of the clock signal based on a comparison between the output value and a reference value; and
adjusting the clock signal based on the status.

2. The method of claim 1, wherein the determining the status includes identifying the clock signal as leading with respect to the signal, and wherein the adjusting of the clock signal includes increasing a delay of the clock signal.

3. The method of claim 1 or 2, wherein the determining the status includes identifying the clock signal as lagging with respect to the signal, and wherein the adjusting of the clock signal includes advancing the clock signal.

4. The method of any one of claims 1 to 3, wherein the computation includes at least one of a sum, average, or mode of at least the first value and the second value.

5. The method of claim 4, wherein the sum is based on a plurality of values taken at a plurality of clock edges, the plurality of values including the first value and the second value, and wherein the reference value is based on the number of values in the plurality of values.

6. The method of claim 5, wherein the reference value is based on the number of the values divided by two.

7. The method of claim 1, wherein the clock signal includes K number of phases, and the method further comprises:
determining one or more values of the signal taken at one or more K^{th} clock edge;
determining one or more values of the signal taken at one or more K^{th}+M clock edge, where M is equal to or greater than 1 and less than K;
determining a first sum of the one or more values of the signal taken at the one or more K^{th} clock edge;
determining a second sum of the one or more values of the signal taken at the one or more K^{th}+M clock edge;
comparing the first sum to the reference value;
comparing the second sum to the reference value;
determining a first status based on the comparison between the first sum and the reference value;
determining a second status based on the comparison between the second sum and the reference value; and
determining the status of the clock signal based at least in part on the first status and the second status.

8. The method of claim 7, wherein the first status is one of leading, lagging, or aligned with respect to the signal, and wherein the second status is one of leading, lagging, or aligned with respect to the signal, and wherein the method further comprises:
determining the status of the clock signal as leading with respect to the signal based on a majority of at least the first status and the second status being leading with respect to the signal.

9. The method of claim 7 or 8, wherein the first status is one of leading, lagging, or aligned with respect to the signal, and wherein the second status is one of leading, lagging, or aligned with respect to the signal, and wherein the method further comprises:
determining the status of the clock signal as lagging with respect to the signal based on a majority of at least the first status and the second status being lagging with respect to the signal.

10. The method of any one of claims 1 to 9, wherein the reference value is calculated based on an assumption of jitter in the clock signal.

11. A system comprising:
a processing circuit; and
a memory storing instructions, which, based on being executed by the processing circuit, cause the processing circuit to perform:
determining a first value of a signal at a first clock edge of a clock signal;
determining a second value of the signal at a second clock edge of the clock signal;
generating an output value based on a computation of at least the first value and the second value;
determining a status of the clock signal based on a comparison between the output value and a reference value; and
adjusting the clock signal based on the status.

12. The system of claim 11, wherein the determining the status includes identifying the clock signal as leading with respect to the signal, and wherein the adjusting of the clock signal includes increasing a delay of the clock signal.

13. The system of claim 11 or 12, wherein the determining the status includes identifying the clock signal as lagging with respect to the signal, and wherein the adjusting of the clock signal includes advancing the clock signal.

14. The system of any one of claims 11 to 13, wherein the computation includes at least one of a sum, average, or mode of at least the first value and the second value.

15. The system of claim 14, wherein the sum is based on a plurality of values taken at a plurality of clock edges, the plurality of values including the first value and the second value, and wherein the reference value is based on the number of values in the plurality of values.
